# FASCICULE DE BREVET EUROPEEN

(11) **EP 3 389 097 B1**
(45) Date de publication et mention de la délivrance du brevet: **12.02.2020**
(21) Numéro de dépôt: 18166723.9
(22) Date de dépôt: 11.04.2018
(51) Int. Cl.: H01L 31/0232

(54) **PHOTODIODE**
FOTODIODE
PHOTODIODE

(30) Priorité: 13.04.2017 FR 1753242
(43) Date de publication de la demande: 17.10.2018
(73) Titulaire: Commissariat à l'Énergie Atomique et aux Énergies Alternatives, 75015 Paris (FR)
(72) Inventeur: HASSAN, Karim, 89470 MONETEAU (FR); BOUTAMI, Salim, 38100 GRENOBLE (FR); KOPP, Christophe, 38120 FONTANIL-CORNILLON (FR)
(74) Mandataire: Colombo, Michel

(56) Documents cités:
- US-A1- 2004 017 975
- US-A1- 2007 189 688
- US-A1- 2009 324 164
- RAYMOND J. HAWKINS ET AL: "Optical power transfer in vertically integrated impedance-matched waveguide/photodetectors: physics and implications for diode-length reduction", OPTICS LETTERS, vol. 16, no. 7, 1 avril 1991 (1991-04-01), page 470, XP055440795, ISSN: 0146-9592, DOI: 10.1364/OL.16.000470

## Description

L'invention concerne une photodiode pour la détection d'un signal optique.

Des photodiodes connues comportent :
- un substrat qui s'étend principalement dans un plan appelé « plan du substrat »,
- des première et seconde prises de contact,
- des premier et second guides d'onde qui présentent, sur toute leur longueur, des indices effectifs de propagation différents, chacun de ces guides d'onde comportant un cœur entouré d'une gaine, le signal optique se propageant essentiellement à l'intérieur du cœur, les cœurs des premier et second guides d'onde s'étendant chacun principalement parallèlement au plan du substrat et étant optiquement couplés l'un à l'autre, le cœur du second guide d'onde étant réalisé en germanium ou en SiGe pour transformer le signal optique en charges électriques,
- des première et seconde régions de dopages opposés qui raccordent électriquement le cœur du second guide d'onde, respectivement, aux première et seconde prises de contact de sorte que l'intensité du courant entre les première et seconde prises de contact varie en fonction de la puissance du signal optique absorbé par le cœur du second guide d'onde.

Une telle photodiode connue est par exemple décrite dans l'article suivant : Vivien L. et Al : « 42 GHz p.i.n Germanium photodetector integrated in a silicon-on-insulator waveguide », Optics Express, Vol. 17, N°8, 13/4/2009, pages 6252-6257. Par la suite, cet article est nommé Vivien2009. Dans cet article, le cœur du premier guide d'onde est réalisé en silicium et le cœur du second guide d'onde est réalisé en germanium. L'extrémité du cœur en silicium vient en appui directement sur une extrémité en vis-à-vis, appelée « entrée », du cœur en germanium. Un tel couplage optique entre les cœurs des guides d'onde en silicium et en germanium est connu sous le terme anglais de « Butt-coupling ».

Dans une telle photodiode, le profil d'absorption du signal optique à l'intérieur du cœur en germanium décroît exponentiellement. Ainsi, l'absorption du signal optique est maximale au niveau de l'entrée du cœur en germanium, puis décroît très rapidement. Par ailleurs, la densité d'énergie du signal optique à l'intérieur du cœur en germanium ne doit pas dépasser une limite fixée. Par exemple, cette limite est fixée pour correspondre à la limite au-delà de laquelle la densité d'énergie du signal optique risque de provoquer des dégradations irréversibles du cœur en germanium.

Dans ces conditions, pour accroître la puissance maximale du signal optique qui peut être absorbé par la photodiode connue sans dépasser la densité d'énergie maximale admissible, il est connu d'accroître les dimensions transversales du cœur en germanium. En effet, pour un signal optique de même puissance, accroître les dimensions transversales du cœur en germanium permet de diminuer la densité d'énergie de ce signal optique au niveau de l'entrée du cœur en germanium. Cette technique permet d'augmenter la puissance maximale du signal optique qui peut être absorbé par la photodiode. Toutefois, elle présente l'inconvénient d'augmenter le volume du cœur en germanium. Elle présente aussi l'inconvénient de ralentir la photodiode, c'est-à-dire que la photodiode réagit plus lentement à la présence d'un signal optique.

Le même problème se pose lorsque le germanium est remplacé par du SiGe.

De l'état de la technique est également connu de US2004/017975A1, US2007/189688A1, US2009/324164A1 et de l'article suivant : Raymond J. Hawkins et Al : « Optical power transfer in vertically integrated impedance-matched waveguide/photodetectors : physics and implications ofr diode-length réduction », Optics Letters, Vol. 16, n°7, 1/04/1991, page 470.

L'invention vise à remédier à cet inconvénient en proposant une photodiode qui, à volume égal de germanium ou de SiGe avec des photodiodes connues, permet d'absorber, sans dégradation de la photodiode, des signaux optiques de puissance plus importante.

Elle a donc pour objet une telle photodiode conforme à la revendication 1.

Comme le montrent les simulations numériques décrites plus loin, le profil d'absorption du signal optique dans la photodiode revendiquée est pratiquement linéaire. Ainsi, l'absorption du signal optique est plus uniformément distribuée sur toute la longueur du cœur du second guide d'onde de la photodiode revendiquée. Dès lors, la densité d'énergie du signal optique absorbé ne présente plus un maximum marqué au niveau de l'entrée du cœur en germanium ou en SiGe. Dans les photodiodes connues, ce maximum limite la puissance du signal optique que la photodiode peut absorber. Dès lors, à dimensions égales du cœur en germanium ou en SiGe, la photodiode revendiquée permet d'absorber un signal optique de puissance plus importante que les photodiodes connues. En effet, l'absorption du signal optique est mieux répartie sur toute la longueur du cœur en germanium ou en SiGe.

Les modes de réalisation de la photodiode peuvent comporter une ou plusieurs des caractéristiques des revendications dépendantes.

L'invention sera mieux comprise à la lecture de la description qui va suivre, donnée uniquement à titre d'exemple non limitatif et faite en se référant aux dessins sur lesquels :
- La figure 1 est une illustration schématique, en coupe verticale et transversale, d'une photodiode ;
- La figure 2 est une illustration schématique, en coupe verticale et longitudinale, de la photodiode de la figure 1 ;
- La figure 3 est une illustration schématique et partielle, en vue de dessus, de la photodiode de la figure 1 ;
- La figure 4 est un graphe représentant le profil d'absorption de la photodiode de la figure 1;
- La figure 5 est un organigramme d'un procédé de fabrication de la photodiode de la figure 1 ;
- Les figures 6 à 12 sont des illustrations schématiques, en coupe transversale, de différents états de fabrication de la photodiode de la figure 1.

Dans ces figures, les mêmes références sont utilisées pour désigner les mêmes éléments. Dans la suite de cette description, les caractéristiques et fonctions bien connues de l'homme du métier ne sont pas décrites en détail.

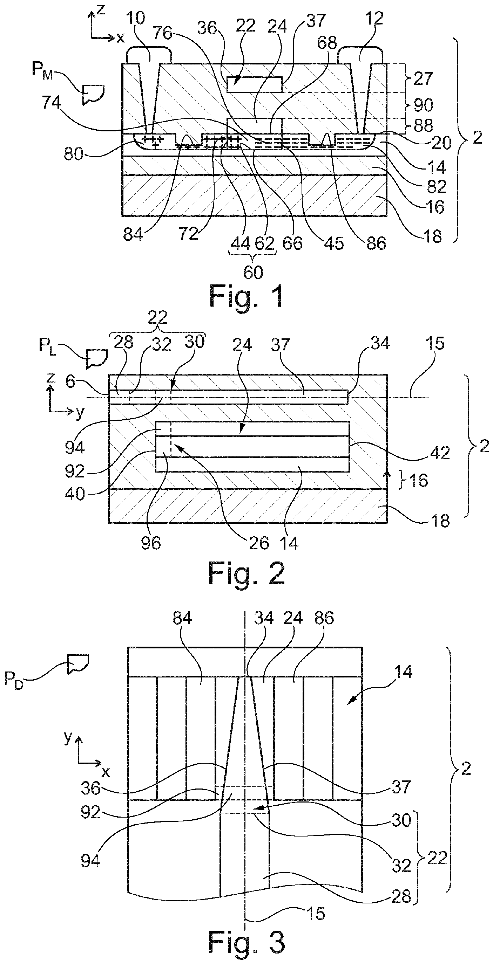

Les figures 1, 2 et 3 représentent une photodiode 2 apte à détecter un signal optique entrant par une entrée 6 de la photodiode 2. Plus précisément, la photodiode 2 convertit le signal optique en un signal électrique généré entre deux prises de contact 10 et 12 (figure 1). Typiquement, la longueur d'onde λ du signal optique à détecter est comprise entre 1260 nm et 1625 nm et, de préférence entre 1260 nm et 1360 nm (bande O) ou entre 1530 nm et 1565 nm (bande C). Ici, la longueur d'onde λ est égale à 1310 nm.

La photodiode 2 comporte une dalle 14 en silicium qui s'étend dans un plan horizontal P_{D} appelé « plan de la dalle ». Dans cette demande, les figures sont orientées par rapport à un repère orthogonal XYZ. Les directions X et Y sont horizontales et la direction Y est parallèle à un axe optique 15 le long duquel se propage le signal optique à l'intérieur de la photodiode 2. La direction Z représente la verticale. Dans ce texte, les termes tels que « supérieur », « inférieur », « au-dessus », « au-dessous » sont définis par rapport à la direction Z.

Ici, les expressions « éléments réalisés en matériau M », « éléments en matériau M » ou « éléments M » désignent le fait que plus de 95 % et, de préférence, plus de 97 % ou 99 % de la masse de cet élément est constitué par le matériau M.

Dans ce mode de réalisation, la dalle 14 est formée par la couche en silicium monocristallin d'un substrat SOI (« Silicon-On-Insulator »). Par conséquent, elle s'étend directement sur une couche diélectrique 16 elle-même directement déposée sur un substrat 18.

L'épaisseur e₁₄ de la dalle 14 est typiquement supérieure à 50 nm ou 100 nm et généralement inférieure à 1 µm . Ici, l'épaisseur e₁₄ est égale à 300 nm.

La dalle 14 présente une face supérieure horizontale 20 du côté opposé au substrat 18.

La couche 16 est réalisée dans un matériau dont l'indice de réfraction nᵣ₁₆ est inférieur à 0,8nᵣ₁₄ ou 0,7nᵣ₁₄, où nᵣ₁₄ est l'inde de réfraction du matériau de la dalle 14. Par exemple, la couche 16 est réalisée en oxyde de silicium (SiO₂) ou en nitrure de silicium. Le substrat 18 est par exemple en silicium. Son épaisseur est typiquement supérieure à 140 µm ou 500 µm ou 725 µm.

La photodiode 2 comporte :
- un premier guide d'onde comprenant un cœur 22 et une gaine,
- un ruban d'adaptation 24, et
- un second guide d'onde comprenant un cœur 26 en germanium.
Dans ce mode de réalisation, la photodiode 2 est symétrique par rapport à un plan longitudinal vertical P_{L} contenant l'axe optique 15. Le ruban 24 et le cœur 26 sont en plus symétriques par rapport à un plan médian vertical P_{M} perpendiculaire à l'axe 15.

Le cœur 22 amène le signal optique à détecter. Il est couplé optiquement au cœur 26 par l'intermédiaire du ruban 24. Le cœur 22 s'étend le long de l'axe 15 dans un plan horizontal situé au-dessus du ruban 24. Son épaisseur e₂₂ est ici constante. Généralement, l'épaisseur e₂₂ est supérieure ou égale à 50 nm ou 100 nm et, de préférence, inférieure à 350 nm ou 1000 nm. Ici, l'épaisseur e₂₂ est égale à 300 nm.

Dans ce mode de réalisation, le cœur 22 est en silicium monocristallin. Le cœur 22 est encapsulé dans une couche 27 en oxyde de silicium qui forme la gaine du premier guide d'onde. Le cœur 22 est délimité, dans la direction X, par des flancs latéraux verticaux situés chacun d'un côté respectif de l'axe 15.

Le cœur 22 comporte successivement, dans la direction Y, une section parallélépipédique 28 et une terminaison fuselée 30. La section 28 s'étend le long de l'axe 15 depuis l'entrée 6 jusqu'au début 32 de la terminaison 30. La terminaison 30 s'étend elle aussi le long de l'axe 15 depuis le début 32 jusqu'à une extrémité distale 34 au-delà de laquelle le cœur 22 s'arrête. Sur les figures 2 et 3, la position du début 32 est représentée par une ligne en pointillés.

La section 28 est conformée pour guider le signal optique reçu sur l'entrée 6 jusqu'à la terminaison 30. Ici, elle est conformée pour guider un seul mode du signal optique de sorte que le premier guide d'onde est un guide d'onde monomode. A l'intérieur de la section 28, les flancs verticaux du cœur 22 s'étendent parallèlement l'un à l'autre. La section 28 ne forme qu'un seul bloc de matière avec la terminaison 30.

A l'intérieur de la terminaison 30, la section transversale du cœur 22 se rétrécit progressivement et continûment au fur et à mesure que l'on se rapproche de l'extrémité 34. Ainsi, à l'intérieur de la terminaison 30, des flancs verticaux 36, 37 de la terminaison 30 se rapprochent progressivement l'un de l'autre.

En pratique, à cause d'imperfections dans le procédé de fabrication de la photodiode 2, les flancs verticaux et les bords verticaux décrits ici ne sont pas parfaitement verticaux. Par exemple, l'angle entre les flancs ou bords verticaux et l'horizontale est compris entre 80° et 100°. Sur les figures et dans la suite de cette description, ces imperfections sont ignorées.

Les projections orthogonales des flancs 36, 37 dans un plan horizontal contenant l'axe 15 forment deux courbes f₁(y) et f₂(y) qui se rapprochent chacune progressivement de l'axe 15. « y » est l'abscisse de ces courbes f₁(y) et f₂(y) le long de l'axe 15. Les courbes f₁(y) et f₂(y) sont continues et dérivables en tout point sauf au niveau du début 32 et de l'extrémité 34. Ici, ces courbes f₁(y) et f₂(y) se rapprochent de l'axe 15 selon une loi en 1/y³ dans le cas où l'origine de l'abscisse y est située au niveau du début 32.

Par la suite, lorsque l'on parle de « largeur » du cœur d'un guide d'onde, on désigne la distance la plus courte, mesurée dans la direction X, entre les flancs latéraux verticaux de ce cœur. Cette largeur est typiquement comprise entre 200 nm et 3 µm. Ici, la largeur de la terminaison 30 est égale à 275 nm au niveau du début 32 et égale à 120 nm au niveau de l'extrémité 34.

Le cœur 26 absorbe le signal optique qu'il reçoit. Plus précisément, il transforme le signal optique en charges électriques. A cet effet, il est réalisé en germanium. Le cœur 26 est rectiligne et s'étend parallèlement à l'axe 15 dans un plan horizontal depuis une entrée 40 jusqu'à une fin 42. L'entrée 40 est le côté du cœur 26 le plus éloigné de l'extrémité 34. Le cœur 26 est situé sous le ruban 24. Son épaisseur e₂₆ est constante. Généralement, l'épaisseur e₂₆ est supérieure ou égale à 50 nm ou 100 nm et, de préférence, inférieure à 350 nm ou 500 nm. Ici, l'épaisseur e₂₆ est égale à 250 nm. Dans ce mode de réalisation, sa section transversale est rectangulaire et constante sur toute sa longueur dans la direction Y. Il est donc délimité, dans la direction X, par des flancs latéraux verticaux 44 et 45 symétriques l'un de l'autre par rapport au plan P_{L}. Sa largeur, dans la direction X, est typiquement comprise entre 200 nm et 3 µm. Ici, sa largeur est égale à 800 nm.

Le cœur 26 est logé à l'intérieur d'une cavité 60 creusée dans la dalle 14. La cavité 60 comporte un fond horizontal 62 et des bords verticaux réalisés à l'intérieur de la dalle 14. Les bords verticaux sont confondus avec les flancs latéraux 44 et 46 du cœur 26.

La profondeur P₆₀ de la cavité 60 est strictement inférieure à l'épaisseur e₁₄ de la dalle 14. Par exemple, l'écart entre l'épaisseur e₁₄ et la profondeur P₆₀ est supérieur ou égal à 20 nm ou 30 nm de sorte qu'il subsiste une fine couche de silicium sous la cavité 60. Ici, l'écart entre l'épaisseur e₁₄ et la profondeur P₆₀ est égale à 50 nm. Pour les simulations numériques, la profondeur P₆₀ est choisie égale à 250 nm.

La section horizontale de la cavité 60 est identique à la section horizontale du cœur 26.

Le cœur 26 s'étend verticalement depuis une face horizontale inférieure 66 jusqu'à une face supérieure 68 du côté opposé. Les faces 66 et 68 sont reliées l'une à l'autre par les flancs latéraux verticaux 44, 45. La face 66 est plane et repose directement sur le fond de la cavité 60. Ici, l'épaisseur e₂₆ du cœur 26 est égale à la profondeur P₆₀ de la cavité 60. Ainsi, la face 68 affleure la face 20 de la dalle 14.

Pour obtenir un courant à partir des charges électriques générées par le signal optique lorsqu'il interagit avec le germanium, le cœur 26 est agencé pour former une diode PiN (« Positive intrinsic Negative »). À cet effet, dans la direction X, le cœur 26 comporte trois régions contiguës de dopages différents, à savoir :
- une région 72 dopée P,
- une région intrinsèque 74 (« intrinsic region » en anglais), et
- une région 76 dopée N.

Ici, la région 74 s'étend horizontalement dans le plan P_{L} et les régions 72 et 76 sont situées de part et d'autre du plan longitudinal P_{L}. Les régions 72 et 76 s'étendent jusqu'aux flancs verticaux, respectivement, 44 et 45.

Pour qu'un courant puisse traverser la photodiode 2, la région 72 est électriquement raccordée à la prise 10 par l'intermédiaire d'une région 80 dopée P réalisée à l'intérieur de la dalle 14. Plus précisément, la région 80 s'étend depuis le flanc vertical 44 du cœur 26, jusqu'à une extrémité inférieure de la prise 10. La région 80 est généralement plus dopée que la région 72. La région 76 est électriquement raccordée à la prise 12 par l'intermédiaire d'une région 82 dopée N réalisée dans la dalle 14. La région 82 s'étend depuis le flanc vertical 45 du cœur 26 jusqu'à l'extrémité inférieure de la prise 12. La région 82 est généralement plus dopée que la région 76.

Des tranchées 84 et 86 sont creusées, respectivement, dans les régions 80 et 82. Ces tranchées s'étendent parallèlement à la direction Y sur toute la longueur du cœur 26. Au niveau de ces tranchées 84, 86, l'épaisseur de la dalle 14 est amincie ce qui permet de confiner plus efficacement le signal optique à l'intérieur du cœur 26.

Le ruban 24 permet d'obtenir un profil d'absorption optique pratiquement linéaire le long de la direction Y. À cet effet, le ruban 24 est, d'un côté, couplé optiquement, par un couplage évanescent, au cœur 26, et d'un côté opposé, couplé optiquement au cœur 22 par un couplage modal. Les couplages évanescents sont bien connus. Par exemple, ils sont définis dans l'article suivant : R. G. Hunsperger, Integrated Optics : Theory and Technology (Springer, 2002), pages 154-155.

Les couplages modaux sont également bien connus. Par exemple, ils sont définis dans l'article suivant : D. Dai et al., « Silicon mode (de)multiplexer enabling high capacity photonic networks-on-chip with a single-wavelength-carrier light », Optics Letter 38(9), pp 1422-1424, 2013.

Un couplage adiabatique, tel que décrit dans l'article suivant est un cas particulier d'un couplage modal: Amnon Yariv et al., « Supermode Si/III-V hybrid Lasers, optical amplifiers and modulators: proposai and analysis » Optics Express 9147, vol. 14, No. 15, 23/07/2007.

Ici, le ruban 24 est réalisé dans le même matériau que le cœur 22. Il est encapsulé à l'intérieur d'une couche 88 d'oxyde de silicium. Le ruban 24 forme ainsi un guide d'onde dont le cœur est en silicium et dont la gaine est en oxyde de silicium.

Pour obtenir un bon couplage évanescent entre le ruban 24 et le cœur 26, le ruban 24 est directement déposé sur la face supérieure 68 du cœur 26. Son épaisseur e₂₄ est constante et généralement supérieure ou égale à 50 nm ou 100 nm et, typiquement, inférieure à 350 nm ou 500 nm. Ici, l'épaisseur e₂₄ du ruban 24 est égale à 200 nm.

La section transversale du ruban 24 est rectangulaire et constante sur toute la longueur du ruban 24 dans la direction Y. Sa largeur, dans la direction X, est inférieure ou égale à la largeur du cœur 26. Ici, sa largeur est égale à la largeur du cœur 26. Sa longueur, dans la direction Y, est ici égale à la longueur du cœur 26 dans la même direction. Ainsi, les projections orthogonales du ruban 24 et du cœur 26 sur un même plan horizontal sont confondues.

Pour obtenir un couplage modal entre le ruban 24 et le cœur 22, le ruban 24 est placé sous la terminaison 30 et séparé de cette terminaison 30 par une couche 90 de bas indice. La couche 90 est dite de « bas indice » car elle est réalisée dans un matériau dont l'indice nᵣ₉₀ de réfraction est inférieur ou égal à 0,8nᵣₘᵢₙ ou 0,7nᵣₘᵢₙ ou 0,5 nᵣₘᵢₙ, où nᵣₘᵢₙ est la valeur du plus petit indice de réfraction choisi entre les indices de réfraction nᵣ₂₂ et nᵣ₂₆, où nᵣ₂₂ et nᵣ₂₆ sont les indices de réfraction des matériaux utilisés pour les cœurs, respectivement, 22 et 26. Ici, les indices nᵣ₂₂ et nᵣ₂₆ sont donc les indices de réfraction, respectivement, du silicium et du germanium. Dans cette demande, les différents indices de réfraction sont mesurés dans les mêmes conditions et pour la longueur d'onde du signal optique à détecter. Dans ce mode de réalisation, la couche 90 est réalisée en oxyde de silicium.

La couche 90 s'étend horizontalement entre le cœur 22 et le ruban 24. Son épaisseur e₉₀ est constante. Généralement, l'épaisseur e₉₀ est comprise entre 20 nm et λ, où λ est la longueur d'onde du signal optique reçu sur l'entrée 6.

Pour qu'il existe un couplage modal, il faut qu'il existe des zones 92, 94 en vis-à-vis du ruban 24 et du premier guide d'onde qui présentent pour la longueur d'onde λ des indices effectifs de propagation égaux. Sur les figures 2 et 3, les zones 92, 94 sont délimitées par des lignes en pointillés. Toutefois, ces zones ne forment qu'un seul bloc de matière avec le reste du cœur. L'indice effectif de propagation est aussi connu sous le nom de « constante de phase du mode ». Il est défini par la relation suivante : n_{g} = n_{eff} - λdn_{eff}/dλ, où n_{g} est l'indice de groupe et λ est la longueur d'onde du signal optique guidé par le guide. L'indice effectif de propagation d'un guide d'onde dépend des dimensions du cœur de ce guide d'onde et des matériaux formant ce cœur et la gaine de ce guide d'onde. Il peut être déterminé expérimentalement ou par simulation numérique.

Ici, la zone 94 est située au-dessus de la zone 92 et à l'intérieur de la terminaison 30. Les matériaux du cœur 22 et du ruban 24 sont identiques. Par conséquent, les dimensions de la section transversale du cœur 22 à l'intérieur de la zone 94 sont ajustées pour que l'indice effectif n_{eff94} de propagation du premier guide d'onde à l'intérieur de la zone 94 soit égale à l'indice effectif n_{eff92} de propagation du ruban 24 à l'intérieur de la zone 92. Étant donné qu'ici l'épaisseur du cœur 22 est constante, c'est la largeur de la terminaison 30 à l'intérieur de la zone 94 qui est ajustée pour obtenir l'égalité n_{eff92} = n_{eff94}. De plus, lors de cet ajustement de la largeur de la terminaison 30 à l'intérieur de la zone 94, le choix d'avoir une largeur qui décroît progressivement et continûment dans la direction Y est maintenu.

L'homme du métier sait réaliser un tel ajustement. Par exemple, typiquement, l'épaisseur e₉₀ et la largeur de la zone 94 sont ajustées expérimentalement, par exemple à l'aide de simulations numériques, jusqu'à obtenir l'épaisseur e₉₀ et la largeur qui conviennent. À cet effet, l'homme du métier peut modéliser et simuler la photodiode à l'aide de logiciel de simulations numériques implémentant la méthode FDTD - 3D (« Finite-Difference Time-Domain 3 Dimensions »). La méthode BPM - 3D (« Beam Propagation Method - 3 Dimensions ») peut aussi être utilisée.

La zone 92 est située juste au-dessus d'une zone 96 en vis-à-vis du cœur 26. La zone 96 se situe à l'intérieur du premier quart du cœur 26. Le premier quart du cœur 26 correspond à la portion du cœur 26 qui s'étend depuis l'entrée 40, dans la direction Y, sur un quart de sa longueur. Ici, la zone 96 est située à l'extrémité droite du cœur 26 et jouxte donc l'entrée 40. Grâce à cela, le signal optique rentre dans le cœur 26 dès son début.

Ainsi, le cœur 22 est optiquement couplé au cœur 26 successivement par un couplage modal réalisé entre le cœur 22 et le ruban 24 suivi d'un couplage évanescent réalisé entre le ruban 24 et le cœur 26.

Lors du fonctionnement de la photodiode 2, le signal optique est transféré du cœur 22 jusqu'au cœur 26 par l'intermédiaire, d'abord du couplage modal entre le cœur 22 et le ruban 24, puis par l'intermédiaire du couplage évanescent entre le ruban 24 et le cœur 26. Si les longueurs, dans la direction Y, des cœurs 22, 26 et du ruban 24 sont suffisamment grandes, il est observé que le signal optique oscille entre les cœurs 22 et 26. Autrement dit, le long de la direction Y, il existe des points Pt1 régulièrement répartis où le signal optique est entièrement à l'intérieur du cœur 22 et des points Pt2 situés à mi-distance entre les points Pt1, où le signal optique est entièrement à l'intérieur du cœur 26. La distance entre deux points Pt1 successifs est égale à la période Pₒ d'oscillation du signal optique entre les cœurs 22 et 26. Cette période Pₒ est proportionnelle à la différence entre les indices effectifs de propagation des premier et second guides d'onde. Typiquement, la période Pₒ est proportionnelle ou égale à λ/Δneff, où Δneff est la différence d'indices effectifs entre le premier guide et le ruban. Ici, pour éviter ces oscillations et raccourcir la longueur de la photodiode 2, le couplage modal entre le premier guide et le ruban 24 est contrôlé par la forme de la terminaison fuselée 30. Par exemple, la forme de la terminaison 30 est conçue pour rendre de plus en plus difficile le retour du signal optique vers le cœur 22, au fur et à mesure que le signal optique qui se propage à l'intérieur du cœur 26 se rapproche de la fin 42. Avec un tel agencement de la terminaison 30, généralement, la longueur du cœur 26 est comprise entre 1 µm et 100 µm et, de préférence, entre 15 µm et 50 µm ou entre 20 µm et 40 µm. Pour les simulations décrites ci-dessous, la longueur du cœur 26 est égale à 40 µm. Ici, la longueur de la section de la terminaison 30 comprise entre la zone 94 et l'extrémité 34 est aussi égale à la longueur du cœur 26.

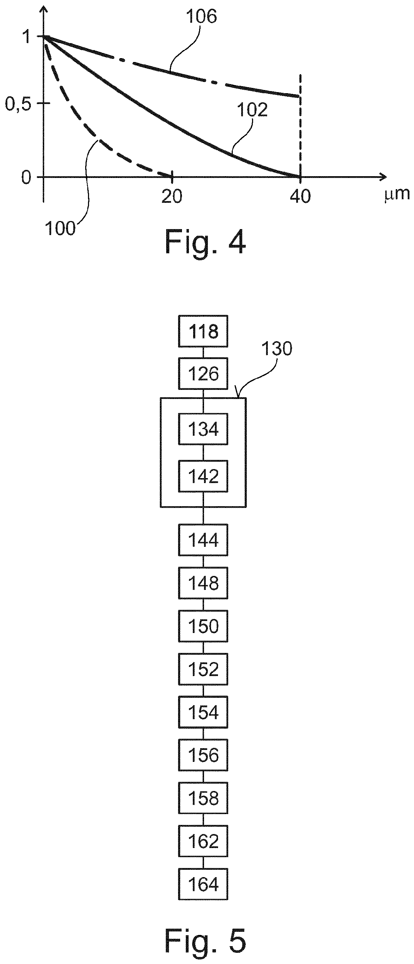

La figure 4 représente des profils 100, 102 et 106 d'absorption du même signal optique obtenu en simulant trois configurations différentes de photodiode. Sur cette figure, l'axe des abscisses représente la distance, dans la direction Y, mesurée depuis l'entrée 40. L'axe des ordonnées représente le taux d'absorption du signal optique par le cœur 26. La valeur « 1 » du taux d'absorption correspond à un taux d'absorption de 0 %, et la valeur « 0 » correspond à un taux d'absorption de 100 % du signal optique à l'intérieur du cœur 26.

Le profil 100 a été obtenu en simulant une configuration identique à la photodiode 2 sauf que :
- le cœur 22 est dépourvu de terminaison fuselée, et
- le cœur 22 est couplé optiquement au cœur 26 en aboutant, dans un même plan horizontal, l'extrémité du cœur 22 à l'entrée 40 du cœur 26.

Un tel couplage optique entre les cœurs 22 et 26 est connu sous le terme anglais de « Butt-coupling ». Cette configuration ne comporte pas de ruban 24. Elle correspond à la configuration décrite dans l'article Vivien2009.

Le profil 102 a été obtenu en simulant la photodiode 2 avec les dimensions décrites précédemment.

Le profil 106 a été obtenu en simulant une configuration identique à celle de la photodiode 2 sauf que le ruban 24 est omis.

Ces simulations ont été réalisées pour une longueur d'onde de 1,31 µm du signal optique et en mettant en œuvre la méthode BPM - 3D.

Le profil 100 montre que dans les configurations connues, le profil d'absorption est fortement non linéaire et qu'un maximum d'absorption se produit au niveau de l'entrée 40 du cœur 26.

Le profil 102 montre qu'au contraire, le profil d'absorption de la photodiode 2 est beaucoup plus linéaire. Ainsi, à dimension égale du cœur 26, la photodiode 2 peut absorber des signaux optiques de puissance plus importante sans dépasser la densité maximale d'énergie fixée comme étant acceptable pour le cœur 26.

Enfin, le profil 106 montre qu'en absence du ruban 24, le profil d'absorption est beaucoup plus linéaire mais l'absorption du signal optique par le cœur 26 est moins efficace. Dès lors, pour absorber pratiquement la totalité du signal optique, il faut fortement augmenter la longueur du cœur 26. Par exemple, dans le cas de la configuration simulée, il faudrait plus que doubler la longueur du cœur 26 pour absorber la même quantité de signal optique qu'avec la photodiode 2. Par « absorber pratiquement la totalité du signal optique », on désigne le fait d'absorber au moins 90 % ou 95 % de l'énergie de ce signal optique.

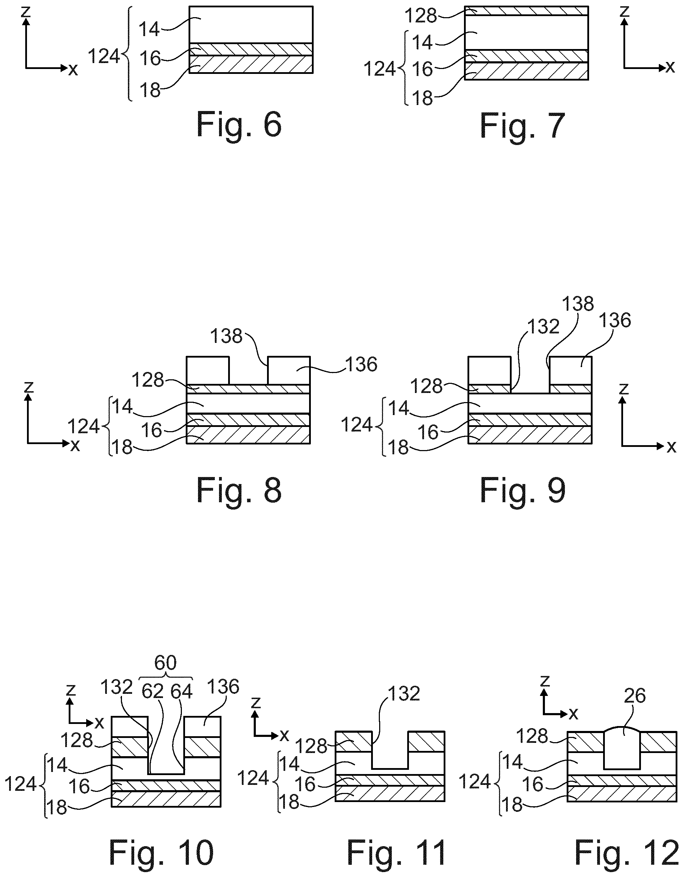

La fabrication de la photodiode 2 va maintenant être décrite à l'aide de l'organigramme de la figure 5 et en référence aux figures 6 à 12.

Le procédé débute par une étape 118 de fourniture d'un substrat SOI 124 (Figure 6) correspondant à l'empilement du substrat 18, de la couche 16 et de la dalle 14.

Lors d'une étape 126, une couche 128 de protection (Figure 7) est déposée sur la face supérieure 20 de la dalle 14. Cette couche 128 est réalisée dans un matériau sur lequel le germanium ne peut pas croître lors d'une opération de croissance du germanium par épitaxie en phase vapeur. Par exemple, la couche 128 est réalisée en dioxyde de silicium. Son épaisseur est typiquement supérieure ou égale à 50 nm et généralement inférieure à 1 µm.

Ensuite, lors d'une étape 130, une cavité 132 (Figure 9) ayant la même section horizontale que le cœur 26 est creusée dans la couche 128 à l'emplacement où doit être réalisée la cavité 60. Par exemple, la cavité 132 est réalisée par photolithographie. À cet effet, lors d'une opération 134, une couche 136 (Figure 8) de résine photosensible est déposée sur la face supérieure de la couche 128. Puis un évidement 138 (Figure 8) qui traverse de part en part l'épaisseur de la couche 136 de résine est réalisé pour mettre à nu la portion de la face supérieure de la couche 128 à graver. La section horizontale de l'évidement 138 est identique à la section horizontale du cœur 26.

Ensuite, lors d'une opération 142, la couche 128 est gravée à travers l'évidement 138 pour obtenir la cavité 132.

Lors d'une étape 144, la cavité 132 (figure 10) est prolongée, dans la direction verticale, à l'intérieur de la dalle 14 pour réaliser la cavité 60 dans cette dalle 14. Lors de cette étape 144, les couches 128 et 136 sont donc utilisées comme un masque, c'est-à-dire que la dalle 14 est gravée à travers les cavités 132 et 138. La gravure de la dalle 14 est interrompue avant d'atteindre la couche 16 pour qu'il subsiste une fine couche de silicium d'au moins 30 nm d'épaisseur entre le fond 62 de la cavité 60 et la couche 16.

Lors d'une étape 148 (figure 11), la couche 136 de résine est retirée pour mettre à nu la face supérieure de la couche 128.

Lors d'une étape 150 (figure 12), on exécute une opération de croissance épitaxiale en phase vapeur de germanium sur le fond 62 de la cavité 60 jusqu'à remplir complètement cette cavité 60. Typiquement, cette opération est réalisée en mettant en œuvre une méthode connue sous l'acronyme RP-CVD (« Reduced Pressure Chemical Vapor Déposition »). Pour cela, une faible épaisseur de germanium est d'abord déposée sous faible température directement sur le fond 62. Par exemple, par faible température, on désigne une température inférieure à 400 °C. Lors de cette première phase, la température est également généralement supérieure à 200 °C. Par faible épaisseur, on désigne une épaisseur inférieure à 50 nm et généralement supérieure ou égale à 30 nm. Ici, lors de la première phase, l'épaisseur de germanium déposée sur le fond 62 est de 40 nm.

Ensuite, on procède à une deuxième phase de croissance sous température plus élevée de la couche de germanium à l'intérieur de la cavité 60. Typiquement, lors de la deuxième phase, la température est supérieure à 650 °C ou 700 °C. Ici, elle est de 730 °C. Cette deuxième phase est utilisée pour déposer au moins 210 nm de germanium à l'intérieur de la cavité 60 et donc complètement remplir cette cavité. À ce stade, l'épaisseur de germanium est égale ou supérieure à l'épaisseur e₂₆ souhaitée.

Un tel procédé de croissance de germanium à l'intérieur d'une cavité est par exemple décrit dans l'article Vivien2009. Ce procédé n'est donc pas décrit ici plus en détail.

Lors de l'étape 150, l'épaisseur e₂₆ de germanium déposée reste inférieure à l'épaisseur critique au-delà de laquelle le nombre de défauts de dislocation du germanium devient très important. Lors de l'étape 150, le germanium croît uniquement à l'intérieur de la cavité 60 et non pas sur la couche 128.

Lors d'une étape 152, la couche 128 est retirée et l'on procède alors au polissage, par exemple un polissage mécanico-chimique ou CMP (Chemical Mecanical Polissing), pour éliminer l'épaisseur de germanium qui dépasse au-delà de la face 20 de la dalle 14 sans pour autant retirer l'épaisseur de germanium logé à l'intérieur de la cavité.

Ensuite, lors d'une étape 154, un dopage localisé du cœur 26 et de la dalle 14 est réalisé pour obtenir les régions dopées 72, 76, 80 et 82. Ce dopage est nécessaire pour récupérer le photo-courant.

Puis, lors d'une étape 156, les tranchées 84, 86 sont gravées à l'intérieure, respectivement, des régions 80 et 82.

Lors d'une étape 158, le ruban 24 est réalisé sur la face 68 du cœur 26. Par exemple, après l'étape 156, le cœur 26 est encapsulé dans la couche 88 d'oxyde de silicium. Une cavité de même dimension et au même emplacement que le futur ruban 24 est creusée dans cette couche 88. Enfin, du silicium amorphe est déposé dans cette cavité pour former le ruban 24. Un polissage mécanico-chimique est alors mis en œuvre pour éliminer l'épaisseur de silicium amorphe qui dépasse au-delà de la face supérieur de la couche 88.

Lors d'une étape 162, la couche 90 de bas indice est déposée puis sa face supérieure est polie pour la préparer à un collage direct également connu sous le nom de « collage moléculaire » ou « direct bonding » en anglais.

Lors d'une étape 164, un second substrat SOI contenant le cœur 22 est collé, par exemple par collage direct, sur la face supérieure de la couche 90 de manière à ce que la terminaison 30 se retrouve en vis-à-vis du ruban 24 et séparée de ce ruban 24 par la seule couche 90. Par exemple, de façon similaire à ce qui a été décrit en référence à la figure 6, ce second substrat SOI comporte un substrat, par exemple en silicium, sur lequel sont successivement déposées un couche diélectrique et une dalle en silicium monocristallin. La fabrication, avant l'étape 164, du premier guide d'onde dans la couche en silicium monocristallin du second substrat SOI est conventionnelle et ne sera pas décrite ici plus en détail. Après le collage du second substrat SOI, le substrat en silicium du second substrat SOI est retiré, par exemple, par amincissement mécanique et polissage CMP avec arrêt sur la couche diélectrique du second substrat SOI. On obtient alors la photodiode 2.

### Variantes du cœur en germanium :

Le cœur 26 peut être réalisé dans d'autres matériaux semi-conducteurs capables d'absorber le signal optique tout en présentant un indice de réfraction au moins 1,1 fois supérieur à celui de la gaine du second guide d'onde. Par exemple, le cœur 26 peut être réalisé en SiGe.

En variante, le cœur 26 ne comporte aucune région dopée. Dans ce cas, ses flancs verticaux non dopés sont directement en contact avec des bords verticaux correspondants des régions 80 et 82.

Dans une autre variante, les longueurs du ruban 24 et du cœur 26 sont strictement supérieures à la période Pₒ d'oscillation du signal optique entre les cœurs 22 et 26. Dans ce cas, il faut plusieurs oscillations du signal optique entre les cœurs 22 et 26 avant qu'il soit pratiquement complètement absorbé par le cœur 26. L'absorption pratiquement complète du signal optique se fait sur une longueur plus importante.

La zone 96 n'est pas nécessairement située à l'intérieur du premier quart du cœur 26. Par exemple, en variante, la zone 96 se situe au milieu du cœur 26.

En variante, le cœur 26 est réalisé sur la face 20 de la dalle 14 en silicium et non pas dans une cavité creusée dans cette dalle 14. Dans ce mode de réalisation, la cavité 60 est donc omise.

En variante, l'épaisseur e₂₆ est strictement supérieure à la profondeur P₆₀ de la cavité 60. Dans ce cas, la face 68 du cœur 26 est en saillie au-dessus de la face 20 de la dalle 14.

### Variantes du cœur 22 :

D'autres formes sont possibles pour la terminaison 30 du cœur 22. Par exemple, les projections orthogonales dans un plan horizontal des flancs verticaux de la terminaison 30 peuvent suivre des trajectoires curvilignes ou rectilignes. Ces flancs peuvent se rapprocher l'un de l'autre rapidement ou, au contraire, très lentement.

Le cœur 22 peut être placé sous le cœur 26 et non pas au-dessus comme décrit précédemment. Dans ce cas, le ruban 24 est situé lui aussi sous le cœur 26.

Le cœur 22 peut-être réalisé dans d'autres matériaux dont les indices de réfraction sont proches de celui du ruban 24, c'est-à-dire compris entre 0,7nᵣ₂₄ et 1,3nᵣ₂₄ et, de préférence, entre 0,9nᵣ₂₄ et 1,1nᵣ₂₄, où nr₂₄ est l'indice de réfraction du matériau utilisé pour fabriquer le ruban 24. Par exemple, lorsque le ruban est en silicium, le cœur 22 peut être réalisé en nitrure de silicium.

Dans une autre variante, l'extrémité 34 de la terminaison 30 dépasse, dans la direction Y, la fin 42 du cœur 26.

Le cœur 22 peut être remplacé par un cœur dimensionné pour que le premier guide d'onde soit multimode.

### Variantes du ruban 24 :

Le ruban 24 peut être réalisé dans d'autres matériaux ayant un indice de réfraction proche de celui du matériau utilisé pour réaliser le cœur 22, c'est-à-dire compris entre 0,7nᵣ₂₂ et 1,3nᵣ₂₂, et de préférence compris entre 0,9nᵣ₂₂ et 1,1nᵣ₂₂ où nᵣ₂₂ est l'indice de réfraction du cœur 22 pour la longueur d'onde λ du signal optique. Par exemple, le ruban peut être réalisé en SiN ou en silicium polycristallin.

D'autres formes sont possibles pour le ruban 24. Par exemple, la projection orthogonale dans un plan horizontal des flancs verticaux du ruban 24 peuvent former un trapèze ou un triangle dont la largeur augmente ou, au contraire, diminue dans la direction Y. Dans ce cas, généralement, le ruban comporte une zone où sa largeur est supérieure à la largeur d'une zone en vis-à-vis de la terminaison 30 et une autre zone où sa largeur est strictement inférieure à la largeur d'une autre zone en vis-à-vis de la terminaison 30.

Le ruban 24 n'est pas nécessairement directement en contact, sur toute sa longueur, avec le cœur 26. En variante, une fine couche de bas indice est interposée entre le ruban 24 et le cœur 26. L'indice de réfraction de cette fine couche est inférieur à 0,8nᵣₘᵢₙ ou inférieur à 0,7 nᵣₘᵢₙ. Par exemple, cette fine couche est réalisée dans le même matériau que la couche de 90. L'épaisseur de cette fine couche est suffisamment petite pour permettre le couplage optique évanescent entre le ruban 24 et le cœur 26. Cette épaisseur est typiquement déterminée par expérimentation et notamment par simulation numérique à l'aide, par exemple, des logiciels de simulation précédemment cités.

La longueur du ruban 24 dans la direction Y peut être supérieure à la longueur du cœur 26 dans cette même direction. Dans ce cas, une extrémité du ruban 24 dépasse le cœur 26. A l'inverse, la longueur du ruban 24 dans la direction Y peut aussi être inférieure à la longueur du cœur 26. Dans ce cas, la fin 42 du cœur 26 dépasse le ruban 24 dans la direction Y.

### Autres variantes possibles de la photodiode :

D'autres matériaux que de l'oxyde de silicium sont possibles pour réaliser les gaines des premier et second guides d'onde. Par exemple, l'oxyde de silicium peut être remplacé par du nitrure de silicium, du TiO₂, du Al₂O₃, du nitrure d'aluminium ou encore d'autre matériaux comme les matériaux chalcogénures.

Après adaptation des dimensions de la photodiode, celle-ci peut être utilisée pour traiter des signaux optiques dont les longueurs d'onde sont comprises dans la bande C, c'est-à-dire pour des longueurs d'onde comprises entre 1500 et 1565 nm.

Dans une autre variante, les tranchées 84 et 86 sont omises.

En variante, le ruban 24 est plus large, dans la direction X que le cœur 26. Dans le cas, dans la direction X, le ruban dépasse de part et d'autre du cœur 26. Dans une autre variante, le ruban 24 est moins large que le cœur 26 dans la direction X. Dans ce dernier cas, la projection orthogonale du ruban 24 sur le plan du substrat est alors strictement comprise à l'intérieure de la projection orthogonale du cœur 26 sur ce même plan.

### Variantes du procédé de fabrication :

Les photodiodes décrites précédemment peuvent aussi être fabriquées par d'autres procédés que le procédé de la figure 5. Par exemple, en variante, la couche 128 est omise lors du procédé de fabrication. Dans ce cas, lors de l'étape de croissance du germanium, la couche de germanium croit également non seulement à l'intérieur de la cavité 60 mais aussi sur la totalité de la face 20 de la dalle 14 en silicium. Ensuite, une étape de polissage, par exemple un polissage mécanico-chimique ou CMP (Chemical Mecanical Polissing) est mise en œuvre pour éliminer l'épaisseur de germanium présent sur la face supérieure 20 de la dalle 14 sans pour autant retirer l'épaisseur de germanium logé à l'intérieur de la cavité 60.

### Avantages techniques des différents modes de réalisation décrits :

Le fait que le ruban 24 soit directement en contact avec le cœur 26, améliore le couplage évanescent entre ce ruban et ce guide. Le signal optique est donc transféré plus efficacement vers le cœur 26, ce qui améliore son absorption par le cœur 26.

Le fait de choisir la longueur du cœur 26 strictement inférieure à 50 µm permet d'éviter les oscillations du signal optique entre les cœurs 22 et 26 lorsque la longueur d'onde du signal optique est comprise entre 1260 nm et 1625 nm. En effet, dans ce cas, cette longueur du cœur 26 est strictement inférieure à la période Pₒ et, de préférence, inférieure à 0,9Pₒ ou 0,7Pₒ. Cela permet donc à la fois de raccourcir la longueur du cœur 26, et donc d'améliorer la compacité de la photodiode, tout en conservant son efficacité.

Le fait que la largeur du ruban 24 soit inférieure ou égale à celle du cœur 26 permet d'améliorer le confinement du signal optique à l'intérieur du cœur 26. On améliore ainsi l'efficacité de la photodiode, c'est-à-dire le rapport entre la puissance initiale du signal optique et l'intensité du courant généré par la photodiode en réponse à l'absorption de ce signal optique.

Le fait que la largeur du ruban 24 soit égale à la largeur du cœur 26 permet à la fois d'améliorer l'efficacité de la photodiode et de diminuer le temps de réponse de la photodiode. Le temps de réponse de la photodiode est le temps nécessaire pour qu'un courant détectable s'établisse entre les prises de contact 10, 12 en réponse à un signal optique. Plus le temps de réponse est court, plus la bande passante de la photodiode est élevée.

Le fait d'agencer le ruban 24 pour que la zone 92 soit située en face du début du cœur 26 permet de raccourcir la longueur du cœur 26.

## Revendications

1. Photodiode pour la détection d'un signal optique, cette photodiode comportant :
- un substrat (18) qui s'étend principalement dans un plan appelé « plan du substrat »,
- des première et seconde prises (10, 12) de contact,
- des premier et second guides d'onde qui présentent, sur toute leur longueur, des indices effectifs de propagation différents, chacun de ces guides d'onde comportant un cœur (22, 26) entouré d'une gaine, le signal optique se propageant essentiellement à l'intérieur du cœur, les cœurs des premier et second guides d'onde s'étendant chacun principalement parallèlement au plan du substrat et étant optiquement couplés l'un à l'autre, le cœur (26) du second guide d'onde étant réalisé en germanium ou en SiGe pour transformer le signal optique en charges électriques,
- des première et seconde régions (80, 82) de dopages opposés qui raccordent électriquement le cœur du second guide d'onde, respectivement, aux première et seconde prises de contact de sorte que l'intensité du courant entre les première et seconde prises de contact varie en fonction de la puissance du signal optique absorbé par le cœur du second guide d'onde,
**caractérisée en ce que** :
- le cœur (22) du premier guide d'onde se termine par une terminaison fuselée (30) qui s'étend parallèlement au plan du substrat au-dessus ou au-dessous du cœur (26) du second guide d'onde,
- la photodiode comporte un ruban d'adaptation (24) qui s'étend d'un côté, en vis-à-vis de la terminaison fuselée et, du côté opposé, en vis-à-vis du cœur du second guide d'onde, ce ruban d'adaptation étant couplé optiquement au cœur du second guide d'onde par un couplage évanescent et comportant une première zone (92) à l'intérieur de laquelle son indice effectif de propagation est égal à l'indice effectif de propagation d'une deuxième zone (94) de la terminaison fuselée située en vis-à-vis de la première zone, ces première et deuxième zones couplant ainsi optiquement la terminaison fuselée au ruban d'adaptation par un couplage modal, et
- la photodiode comporte une couche (90) de bas indice qui s'étend parallèlement au plan du substrat entre le ruban d'adaptation et la terminaison fuselée, cette couche de bas indice étant réalisée dans un matériau dont l'indice de réfraction est inférieur à 0,8nᵣₘᵢₙ, où nᵣₘᵢₙ est la valeur du plus petit indice de réfraction choisi dans le groupe constitué des indices de réfraction des matériaux utilisés pour former les cœurs, respectivement, des premier et second guides d'onde, les indices de réfraction étant mesurés, dans les mêmes conditions, à la longueur d'onde λ du signal optique.

2. Photodiode selon la revendication 1, dans laquelle le ruban d'adaptation (24) est directement mécaniquement en contact avec le cœur (26) du second guide d'onde.

3. Photodiode selon l'une quelconque des revendications précédentes, dans laquelle la longueur du cœur (26) du second guide d'onde dans la direction de propagation du signal optique est inférieure à 50 µm.

4. Photodiode selon l'une quelconque des revendications précédentes, dans laquelle la largeur de toute la section du ruban d'adaptation (24) en vis-à-vis du cœur (26) du second guide d'onde, dans une direction parallèle au plan du substrat et perpendiculaire à la direction de propagation de signal optique, est inférieure ou égale à la largeur du cœur (26) du second guide d'onde dans la même direction.

5. Photodiode selon la revendication 4, dans laquelle la largeur de toute la section du ruban d'adaptation en vis-à-vis du cœur du second guide d'onde est égale à la largeur du cœur (26) du second guide d'onde.

6. Photodiode selon l'une quelconque des revendications précédentes, dans laquelle la première zone (92) du ruban d'adaptation est située en vis-à-vis d'une troisième zone (96) du cœur (26) du second guide d'onde, cette troisième zone étant située dans la direction de propagation du signal optique, à l'intérieur du premier quart du cœur du second guide d'onde.

7. Photodiode selon l'une quelconque des revendications précédentes, dans laquelle la terminaison fuselée (30) comporte des flancs latéraux (36, 37) qui se rapprochent progressivement et continûment l'un de l'autre, en allant dans la direction de propagation du signal optique, depuis la deuxième zone (94) jusqu'à une extrémité distale (34) au-delà de laquelle le cœur (22) du premier guide d'onde n'existe plus.

8. Photodiode selon l'une quelconque des revendications précédentes, dans laquelle le cœur (22) du premier guide d'onde et le ruban d'adaptation sont réalisés en silicium.

9. Photodiode selon l'une quelconque des revendications précédentes, dans laquelle l'épaisseur de la couche (90) de bas indice est supérieure ou égale à 20 nm et inférieure à λ, où λ est la longueur d'onde du signal optique qui se propage à l'intérieur du premier guide d'onde.

10. Photodiode selon l'une quelconque des revendications précédentes, dans laquelle quelle que soit les zones sélectionnées en vis-à-vis des premier et second guides d'onde, la différence entre les indices effectifs de propagation des premier et second guide d'onde à l'intérieur de ces deux zones en vis-à-vis est supérieure à 0,05n_{eff1}, où n_{eff1} est l'indice effectif de propagation à l'intérieur de la zone du premier guide d'onde.

## Patentansprüche

1. Fotodiode zur Detektion eines optischen Signals, wobei diese Fotodiode umfasst:
- ein Substrat (18), das sich hauptsächlich in einer "Ebene des Substrats" genannten Ebene erstreckt,
- erste und zweite Kontaktanschlüsse (10, 12),
- erste und zweite Wellenleiter, die über ihre gesamte Länge unterschiedliche effektive Ausbreitungsindizes aufweisen, wobei jeder dieser Wellenleiter einen von einem Mantel umgebenen Kern (22, 26) umfasst, wobei sich das optische Signal im Wesentlichen im Innern des Kerns ausbreitet, wobei sich die Kerne des ersten und des zweiten Wellenleiters jeweils hauptsächlich parallel zur Ebene des Substrats erstrecken und optisch aneinander gekoppelt sind, wobei der Kern (26) des zweiten Wellenleiters aus Germanium oder aus SiGe ausgeführt ist, um das optische Signal in elektrische Ladungen umzuwandeln,
- erste und zweite Regionen (80, 82) mit entgegengesetzter Dotierung, die den Kern des zweiten Wellenleiters mit dem ersten bzw. zweiten Kontaktanschluss so verbinden, dass die Stärke des Stroms zwischen dem ersten und dem zweiten Kontaktanschluss in Abhängigkeit von der Leistung des vom Kern des zweiten Wellenleiters absorbierten optischen Signals variiert,
**dadurch gekennzeichnet, dass**:
- der Kern (22) des ersten Wellenleiters mit einem spindelförmigen Abschluss (30) endet, der sich parallel zur Ebene des Substrats über oder unter dem Kern (26) des zweiten Wellenleiters erstreckt,
- die Fotodiode einen Anpassungsstreifen (24) umfasst, der sich auf einer Seite gegenüber dem spindelförmigen Abschluss und auf der entgegengesetzten Seite gegenüber dem Kern des zweiten Wellenleiters erstreckt, wobei dieser Anpassungsstreifen mit dem Kern des zweiten Wellenleiters optisch durch eine evaneszente Kopplung gekoppelt ist und einen ersten Bereich (92) umfasst, innerhalb dessen sein effektiver Ausbreitungsindex gleich dem effektiven Ausbreitungsindex eines zweiten Bereichs (94) des spindelförmigen Abschlusses ist, der gegenüber dem ersten Bereich gelegen ist, wobei diese ersten und zweiten Bereiche somit den spindelförmigen Abschluss durch eine modale Kopplung optisch mit dem Anpassungsstreifen koppeln, und
- die Fotodiode eine Niedrigindexschicht (90) umfasst, die sich parallel zur Ebene des Substrats zwischen dem Anpassungsstreifen und dem spindelförmigen Abschluss erstreckt, wobei diese Niedrigindexschicht aus einem Material ausgeführt ist, dessen Brechungsindex geringer als 0,8nᵣₘᵢₙ ist, wobei nᵣₘᵢₙ der Wert des kleinsten Brechungsindex ist, der aus der Gruppe gewählt ist, die aus den Brechungsindizes der Materialien besteht, die verwendet werden, um die Kerne des ersten bzw. des zweiten Wellenleiters zu bilden, wobei die Brechungsindizes unter den gleichen Bedingungen für die Wellenlänge λ des optischen Signals gemessen werden.

2. Fotodiode nach Anspruch 1, bei welcher der Anpassungsstreifen (24) direkt mechanisch in Kontakt mit dem Kern (26) des zweiten Wellenleiters steht.

3. Fotodiode nach einem der vorhergehenden Ansprüche, bei der die Länge des Kerns (26) des zweiten Wellenleiters in Ausbreitungsrichtung des optischen Signals weniger als 50 µm beträgt.

4. Fotodiode nach einem der vorhergehenden Ansprüche, bei der die Breite des gesamten Querschnitts des Anpassungsstreifens (24) gegenüber dem Kern (26) des zweiten Wellenleiters in eine Richtung, die parallel zur Ebene des Substrats und senkrecht zur Ausbreitungsrichtung des optischen Signals verläuft, kleiner als oder gleich der Breite des Kerns (26) des zweiten Wellenleiters in die gleiche Richtung ist.

5. Fotodiode nach Anspruch 4, bei der die Breite des gesamten Querschnitts des Anpassungsstreifens gegenüber dem Kern des zweiten Wellenleiters gleich der Breite des Kerns (26) des zweiten Wellenleiters ist.

6. Fotodiode nach einem der vorhergehenden Ansprüche, bei welcher der erste Bereich (92) des Anpassungsstreifens gegenüber einem dritten Bereich (96) des Kerns (26) des zweiten Wellenleiters gelegen ist, wobei dieser dritte Bereich in Ausbreitungsrichtung des optischen Signals im Innern des ersten Viertels des Kerns des zweiten Wellenleiters gelegen ist.

7. Fotodiode nach einem der vorhergehenden Ansprüche, bei welcher der spindelförmige Abschluss (30) seitliche Flanken (36, 37) umfasst, die sich einander in Ausbreitungsrichtung des optischen Signals vom zweiten Bereich (94) aus bis zu einem distalen Ende (34), jenseits dessen der Kern (22) des ersten Wellenleiters nicht mehr existiert, zunehmend und stetig annähern.

8. Fotodiode nach einem der vorhergehenden Ansprüche, bei welcher der Kern (22) des ersten Wellenleiters und der Anpassungsstreifen aus Silicium ausgeführt sind.

9. Fotodiode nach einem der vorhergehenden Ansprüche, bei der die Dicke der Niedrigindexschicht (90) größer oder gleich 20 nm und kleiner als λ ist, wobei λ die Wellenlänge des optischen Signals ist, das sich im Innern des ersten Wellenleiters ausbreitet.

10. Fotodiode nach einem der vorhergehenden Ansprüche, bei der unabhängig von den ausgewählten Bereichen gegenüber dem ersten und zweiten Wellenleiter die Differenz zwischen den effektiven Ausbreitungsindizes des ersten und des zweiten Wellenleiters im Innern dieser beiden gegenüberliegenden Bereiche größer als 0,05n_{eff1} ist, wobei n_{eff1} der effektive Ausbreitungsindex im Innern des Bereichs des ersten Wellenleiters ist.

## Claims

1. Photodiode for detecting an optical signal, this photodiode including:
- a substrate (18) that extends mainly in a plane called the 'plane of the substrate',
- first and second contact terminals (10, 12),
- first and second waveguides that have, over their entire length, different effective propagation indices, each of these waveguides including a core (22, 26) surrounded by a cladding, the optical signal propagating essentially inside the core, the cores of the first and second waveguides each extending mainly parallel to the plane of the substrate and being coupled optically to one another, the core (26) of the second waveguide being made from germanium or from SiGe so as to transform the optical signal into electrical charges,
- first and second oppositely doped regions (80, 82) that electrically connect the core of the second waveguide, respectively, to the first and second contact terminals, such that the magnitude of the current between the first and second contact terminals varies depending on the power of the optical signal absorbed by the core of the second waveguide,
**characterized in that**:
- the core (22) of the first waveguide terminates in a tapered termination (30) that extends parallel to the plane of the substrate above or below the core (26) of the second waveguide,
- the photodiode includes a matching strip (24) that extends opposite the tapered termination on one side and opposite the core of the second waveguide on the opposite side, this matching strip being coupled optically to the core of the second waveguide by an evanescent coupling and including a first zone (92) inside which its effective propagation index is equal to the effective propagation index of a second zone (94) of the tapered termination situated opposite the first zone, these first and second zones thus optically coupling the tapered termination to the matching strip through a modal coupling, and
- the photodiode includes a low-index layer (90) that extends parallel to the plane of the substrate between the matching strip and the tapered termination, this low-index layer being made from a material whose refractive index is less than 0.8nᵣₘᵢₙ, where nᵣₘᵢₙ is the value of the smallest refractive index chosen from the group consisting of the refractive indices of the materials used to form the cores of the first and second waveguides, respectively, the refractive indices being measured, in the same conditions, at the wavelength λ of the optical signal.

2. Photodiode according to Claim 1, wherein the matching strip (24) is mechanically directly in contact with the core (26) of the second waveguide.

3. Photodiode according to either one of the preceding claims, wherein the length of the core (26) of the second waveguide in the direction of propagation of the optical signal is less than 50 µm.

4. Photodiode according to any one of the preceding claims, wherein the width of the entire cross section of the matching strip (24) opposite the core (26) of the second waveguide, in a direction parallel to the plane of the substrate and perpendicular to the direction of propagation of the optical signal, is less than or equal to the width of the core (26) of the second waveguide in the same direction.

5. Photodiode according to Claim 4, wherein the width of the entire cross section of the matching strip opposite the core of the second waveguide is equal to the width of the core (26) of the second waveguide.

6. Photodiode according to any one of the preceding claims, wherein the first zone (92) of the matching strip is situated opposite a third zone (96) of the core (26) of the second waveguide, this third zone being situated in the direction of propagation of the optical signal, inside the first quarter of the core of the second waveguide.

7. Photodiode according to any one of the preceding claims, wherein the tapered termination (30) includes lateral flanks (36, 37) that gradually and continuously approach one another, going in the direction of propagation of the optical signal, from the second zone (94) as far as a distal end (34) beyond which the core (22) of the first waveguide no longer exists.

8. Photodiode according to any one of the preceding claims, wherein the core (22) of the first waveguide and the matching strip are made from silicon.

9. Photodiode according to any one of the preceding claims, wherein the thickness of the low-index layer (90) is greater than or equal to 20 nm and less than λ, where λ is the wavelength of the optical signal propagating inside the first waveguide.

10. Photodiode according to any one of the preceding claims, wherein, regardless of the selected zones opposite the first and second waveguides, the difference between the effective propagation indices of the first and second waveguides inside these two opposite zones is greater than 0.05n_{eff1}, where n_{eff1} is the effective propagation index inside the zone of the first waveguide.
